# EUROPÄISCHE PATENTANMELDUNG

(11) **EP 1 818 980 A2**
(43) Veröffentlichungstag der Anmeldung: **15.08.2007**
(21) Anmeldenummer: 07109221.7
(22) Anmeldetag: 29.05.2000
(51) Int. Cl.: H01L 23/15, H01L 23/498, H01L 23/60, H05K 1/02

(54) **Substrat für Hochspannungsmodule**

(30) Priorität: 22.06.1999 DE 19928578
(62) Teilanmeldung aus: 00111519.5
(71) Anmelder: Infineon Technologies AG, 85579 Neubiberg (DE)
(72) Erfinder: Stoisiek, Michael, 85521, Ottobrunn (DE); Lefranc, Guy, 80634, Muenchen (DE); Bayerer, Reinhold, 59581, Warstein (DE); Leuschner, Rainer, 77210, Samoreau (FR)
(74) Vertreter: Müller - Hoffmann & Partner

(57) **Zusammenfassung**

Die vorliegende Erfindung betrifft ein Substrat für Hochspannungsmodule mit einer Keramikschicht (1) mit einer ersten Hauptseite (21) und einer der ersten Hauptseite gegenüberliegenden zweiten Hauptseite (22), einer oberen Metallschicht (2) auf der ersten Hauptseite und einer unteren Metallschicht (3) auf der zweiten Hauptseite und einer elektrisch leitfähigen Bodenplatte (5), die über die untere Metallschicht (3) mit der Keramikplatte (1) verbunden ist. Auf der ersten Hauptseite (21) der Keramikschicht (1) ist eine zu der oberen Metallschicht (2) beabstandete Randmetallisierung (20) vorgesehen, die die obere Metallschicht (2) zur Bildung eines Feldaustrittsbereiches (30) rings umgibt und die niederohmig mit der unteren Metallschicht (3) verbunden ist.

## Beschreibung

Die vorliegende Erfindung betrifft die Verbesserung von Metall-Keramik-Substraten für Hochspannungsmodule.

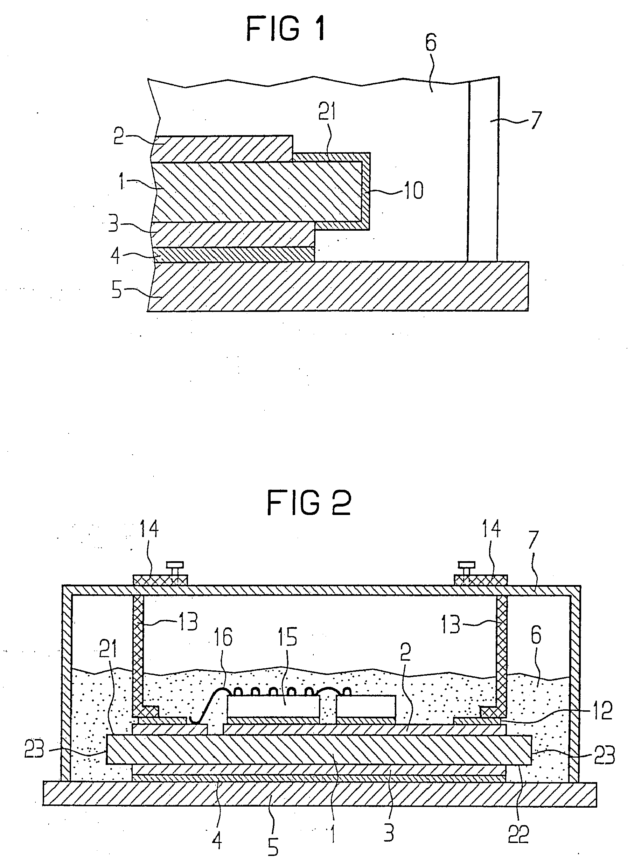

Leistungshalbleiterbauelemente, insbesondere IGBTs, sind auf einem Metall-Keramik-Substrat befestigt. Ein typischer Aufbau ist im Querschnitt in Figur 2 dargestellt. Das verwendete Substrat umfasst eine Keramikschicht 1, die üblicherweise z.B. aus Al₂O₃ oder A1N ist. Auf beiden Hauptseiten 21, 22 dieser Keramikschicht 1 befinden sich Metallschichten 2, 3, die z. B. durch eine Kupfermetallisierung gebildet sind. Bei der Montage wird die untere Metallschicht 3 mittels einer Lötverbindung 4 auf einer Bodenplatte 5, die auch Kupfer sein kann, befestigt. Auf der oberen Metallschicht 2 werden die Leistungshalbleiterbauelemente 15, z. B. ein IGBT oder eine Diode, mittels einer weiteren Lötverbindung 12 befestigt. Die oberen Anschlusskontakte der Leistungshalbleiterbauelemente werden z. B. mittels eines Bonddrahtes 16 zu einem separaten Anteil der oberen Metallschicht 2 geführt. Auf der oberen Metallschicht 2 sind mittels weiterer Lötverbindungen 12 elektrische Zuleitungen 13 angebracht, die zu externen Kontakten 14 zum Abgriff der Betriebsspannung geführt sind. Die Anordnung befindet sich in einem vorzugsweise aus Kunststoff gefertigten Gehäuse 7, das mit einer Vergußmasse 6 aufgefüllt ist. Die Vergußmasse b dient zur elektrischen Isolation gegenüber der Umgebung.

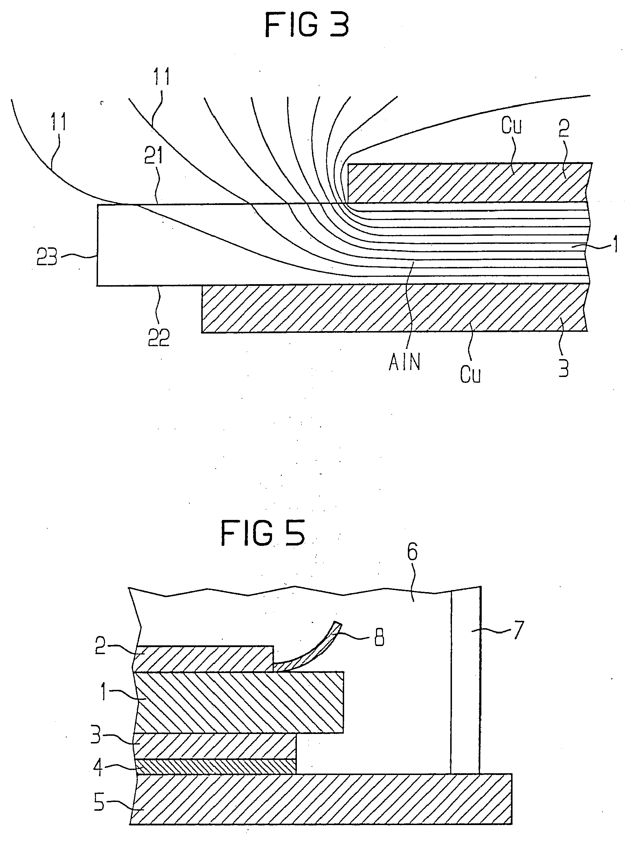

Figur 3 zeigt den typischen Verlauf der Äquipotenzialflächen anhand der durch Äquipotenziallinien 11 gegebenen Querschnitte im Bereich des Randes des Substrates. Die seitlichen Ränder der Metallschichten 2, 3 fallen nicht mit einer seitlichen Begrenzung 23 der Keramikschicht 1 zusammen. Der seitliche Rand der oberen Metallschicht 2 ist bei einer typischen Ausgestaltung weiter von der seitlichen Begrenzung 23 entfernt als der seitliche Rand der unteren Metallschicht 3. Das Substrat ist folglich ähnlich zu einem Sockel ausgebildet. Die Äquipotenziallinien 11 treten aus der mit der oberen Metallschicht 2 versehenen ersten Hauptseite 21 der Keramikschicht 1 aus, wie dies in Figur 3 dargestellt ist. Die elektrische Feldstärke, also der Gradient der Äquipotenzialflächen, ist im Randbereich der Metallschichten 2, 3 besonders groß und kann extreme Spitzenwerte annehmen. Diese hohen auftretenden Feldstärken am Rand der Metallschicht 2 bzw. 3 sind die Ursache für eine hohe Teilentladung des Moduls, die bei der Überschreitung eines Schwellenwertes der Betriebsspannung plötzlich einsetzt und experimentell nachgewiesen wurde. Durch eine derartige hohe Teilentladung wird der Modul, insbesondere die Vergußmasse 6, dauerhaft geschädigt. Die Hochspannungsfestigkeit des Moduls ist damit begrenzt.

Die derzeitige Weiterentwicklung der IGBT-Module ist auf hohe Betriebsspannungen gerichtet, wie sie von Thyristoren bekannt sind. Die Spannungen zwischen Masse und dem elektrisch aktiven Teil des Moduls nehmen Werte oberhalb von 10 kV an, so dass an die Isolierfestigkeit der Module und an ihre Beständigkeit hohe Anforderungen gestellt werden.

Es ist Aufgabe der vorliegenden Erfindung, ein Substrat für Hochspannungsmodule anzugeben, das auch für wesentlich höhere Betriebsspannungen als 3 kV geeignet ist.

Diese Aufgabe wird mit dem Substrat mit den Merkmalen des Anspruches 1 gelöst. Vorteilhafte Ausgestaltungen der Erfindung ergeben sich aus den abhängigen Ansprüchen.

Bei dem vorliegenden Substrat, das eine mit zwei Metallschichten versehene Keramikschicht umfasst, sind anschließend an die Ränder der oberen Metallschicht an der Oberfläche der Keramikschicht Mittel vorhanden, die den Betrag der elektrischen Feldstärke an den Rändern der Metallschichten begrenzen. Das geschieht, um zu verhindern, dass an dieser Stelle hohe elektrische Feldstärken auftreten, die einen mit dem Substrat hergestellten Hochleistungsmodul schädigen können. Daher wird für eine gleichmäßige Verteilung des elektrischen Potenzials an der Oberfläche der Keramikschicht gesorgt. Ein derartiger Potenzialausgleich wird durch eine ausreichend hochohmige und ausreichend dünne elektrisch leitende Schicht an der Oberseite der Keramikschicht herbeigeführt, mit der die Ränder der oberen Metallschicht hochohmig mit der unteren Metallschicht verbunden werden. Dabei ist diese Schicht ausreichend leitfähig, um auch bei schnellen Schaltvorgängen im hohen Spannungsbereich (z.B. typisch 6 kV/µs bis 10 kV/µs) einen ausreichenden Potenzialausgleich herbeizuführen. Es kann vorgesehen sein, an den Rändern der oberen Metallschicht jeweils seitlich einen mit zunehmender Entfernung von dem betreffenden Rand zunehmend nach oben gebogenen elektrischen Leiter anzubringen. Auf der Oberseite der Keramikschicht ist eine zu der oberen Metallschicht beabstandete und die obere Metallschicht umgebende Randmetallisierung vorgesehen, wobei diese Randmetallisierung niederohmig mit der unteren Metallschicht verbunden ist.

Es folgt eine genauere Beschreibung des erfindungsgemäßen Substrates anhand der in den beigefügten Figuren erläuterten Beispiele. Es zeigen:
- Figur 1: den Rand einer Ausführungsform eines MetallKeramik-Substrates,
- Figur 2: den eingangs erläuterten Aufbau eines Hochleistungsmoduls,
- Figur 3: den Verlauf der Äquipotenzialflächen in einem Ausschnitt aus Figur 2,
- Figur 4: ein Ausführungsbeispiel eines erfindungsgemäβen Substrates im Querschnitt einschließlich des Verlaufes der Äquipotenzialflächen,
- Figur 5: ein weiteres Ausführungsbeispiel, und
- Figur 6a - e: Ausführungsbeispiele eines erfindungsgemäßen Substrates im Querschnitt mit verschiedenen Randmetallisierungen.

In Figur 1 ist ein Ausschnitt aus dem Aufbau eines Hochleistungsmoduls gemäß Figur 2 mit einem Substrat im Querschnitt dargestellt. Das Substrat ist ein Metall-Keramik-Substrat, bestehend aus einer Keramikschicht 1, die z. B. Al₂O₃ oder A1N ist, einer oberen Metallschicht 2, z. B. aus Kupfer, sowie einer unteren Metallschicht 3, z. B. ebenfalls aus Kupfer. Die Lötverbindung 4 und die Bodenplatte 5 eines Modul-Aufbaus sind hier ebenfalls eingezeichnet. Das Substrat, von dem hier nur der Rand gezeigt ist, wird zur Herstellung eines Moduls vorzugsweise in eine Vergußmasse 6 eingegossen und in einem Gehäuse 7 angeordnet.

Bei dem in Figur 1 dargestellten Substrat befindet sich auf der ersten Hauptseite 21 der Keramikschicht 1 angrenzend an die obere Metallschicht 2 eine hochohmige Schicht 10 aus einem elektrisch leitfähigen Material. Diese Schicht 10 kann den gesamten nicht mit der oberen Metallschichten 2 bedeckten Anteil der Keramikschicht 1 bedecken. Die hochohmige Schicht ist mit der unteren Metallschicht 3 elektrisch leitend verbunden und bedeckt bei diesem Substrat die seitlichen Berandungen und die zweite Hauptseite der Keramikschicht bis angrenzend an die untere Metallschicht. Grundsätzlich genügt es aber, wenn nur auf der ersten Hauptseite 21 der Keramikschicht 1 anschließend an die Ränder der oberen Metallschicht 2 eine solche hochohmige Schicht 10 vorhanden ist, die mit der unteren Metallschicht 3 derart elektrisch leitend verbunden ist, dass eine Potenzialdifferenz zwischen der oberen und unteren Metallschicht anliegen kann, die über die hochohmige Schicht abfällt. Die Schicht 10 kann zum Beispiel an ihren äußeren Rändern mittels elektrischer Leiterbahnen mit der unteren Metallschicht 3 elektrisch leitend verbunden, d. h. kurzgeschlossen, sein.

Die hochohmige Schicht 10 grenzt vorzugsweise an alle Ränder der oberen Metallschicht 2 an, also nicht nur außen an den Rändern des Substrates, sondern auch zwischen den gegebenenfalls mehreren Anteilen der oberen Metallschicht, wie sie in Figur 2 als Beispiel eingezeichnet sind. Die hochohmige Schicht ist in einer bevorzugten Ausgestaltung so ausgebildet, dass bei Anliegen einer elektrischen Spannung U im Bereich von 3 kV bis 10 kV zwischen der oberen Metallschicht 2 und der unteren Metallschicht 3 der Betrag der elektrischen Feldstärke an den seitlichen Rändern der Metallschicht höchstens 4 V/mm beträgt.

Die hochohmige Schicht 10 ist vorzugsweise ein schwach elektrisch leitendes Material. Sie kann z. B. gebildet werden durch eine dünne Metallschicht, deren spezifischer Widerstand durch Oxidationsprozesse eingestellt werden kann. Dafür ist insbesondere CrNi besonders geeignet. Statt Metall kann elektrisch leitfähig dotiertes amorphes Silizium verwendet werden, dessen Leitfähigkeit durch die Dotierungskonzentration leicht in geeigneter Weise eingestellt werden kann (spezifischer Widerstand beträgt typisch 10⁵Ωcm). Das geschieht insbesondere im Hinblick darauf, dass eine ausreichende elektrische Isolation erforderlich ist, während gleichzeitig ein schneller Potenzialausgleich für Schaltvorgänge gefordert ist, bei denen in kurzer Zeit hohe Spannungsanstiege auftreten. Möglich ist auch die Abscheidung von amorphem Kohlenstoff a-C:H, dessen Leitfähigkeit gezielt mittels Dotierung mit Bor, Stickstoff oder Zinn eingestellt werden kann. Statt eine gesonderte Schicht 10 aufzubringen, kann es genügen, einen Schichtanteil der Keramikschicht 1 zumindest an deren erster Hauptseite 21 z. B. mittels einer Ti-Implantation elektrisch leitfähig zu dotieren.

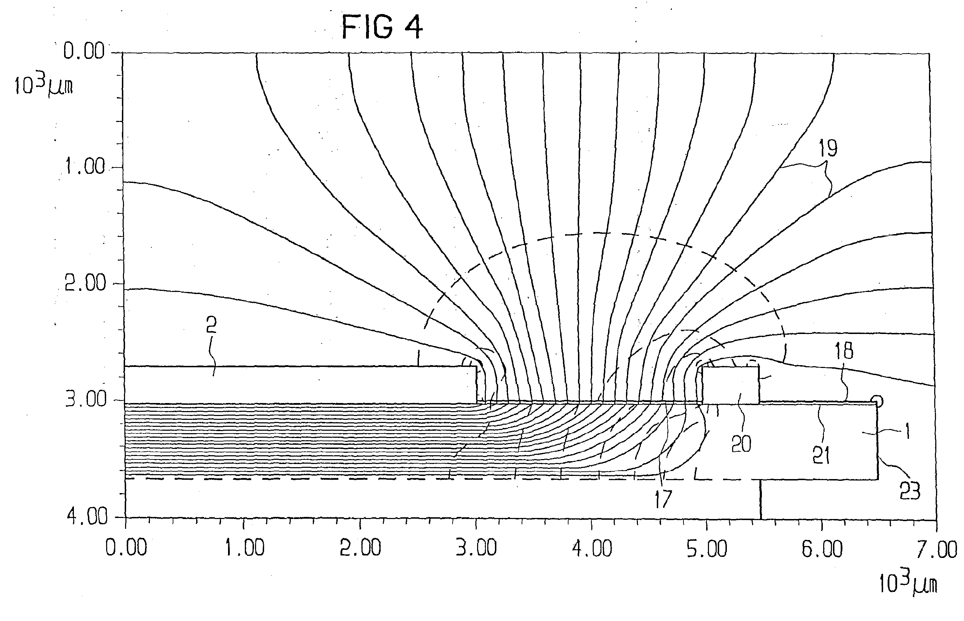

Figur 4 zeigt im Querschnitt ein Ausführungsbeispiel, von dem die Keramikschicht 1 und die obere Metallschicht 2 dargestellt sind. Hierbei ist eine Randmetallisierung 20 vorhanden, die rings um die obere Metallschicht 2 und im Abstand dazu auf der ersten Hauptseite 21 der Keramikschicht 1 angebracht ist. Die Randmetallisierung 20 ist mit der unteren Metallschicht 3 elektrisch leitend verbunden, so dass die Randmetallisierung 20 auf dem elektrischen Potenzial der unteren Metallschicht 3 liegt. Zwischen der oberen Metallschicht 2 und dieser Randmetallisierung 20 befindet sich auf der ersten Hauptseite 21 der Keramikschicht 1 die hochohmige Schicht als innere hochohmige Schicht 17. Falls die obere Metallschicht 2 in mehrere Anteile zerfällt, grenzt die innere hochohmige Schicht 17 vorzugsweise an alle Ränder dieser Anteile an. Die innere hochohmige Schicht 17 kann entsprechend einer hochohmigen Schicht bei den zuvor anhand der Figur 1 beschriebenen Ausführungsformen gebildet sein. Eine äußere leitfähige Schicht 18 zwischen der Randmetallisierung 20 und der seitlichen Berandung 23 der Keramikschicht kann nach Art einer Feldplatte zusätzlich vorhanden sein. Der typische Verlauf der Äquipotenzialflächen bei Anliegen einer Betriebsspannung zwischen der oberen und der unteren Metallschicht ist durch die eingezeichneten Äquipotenziallinien 19 dargestellt.

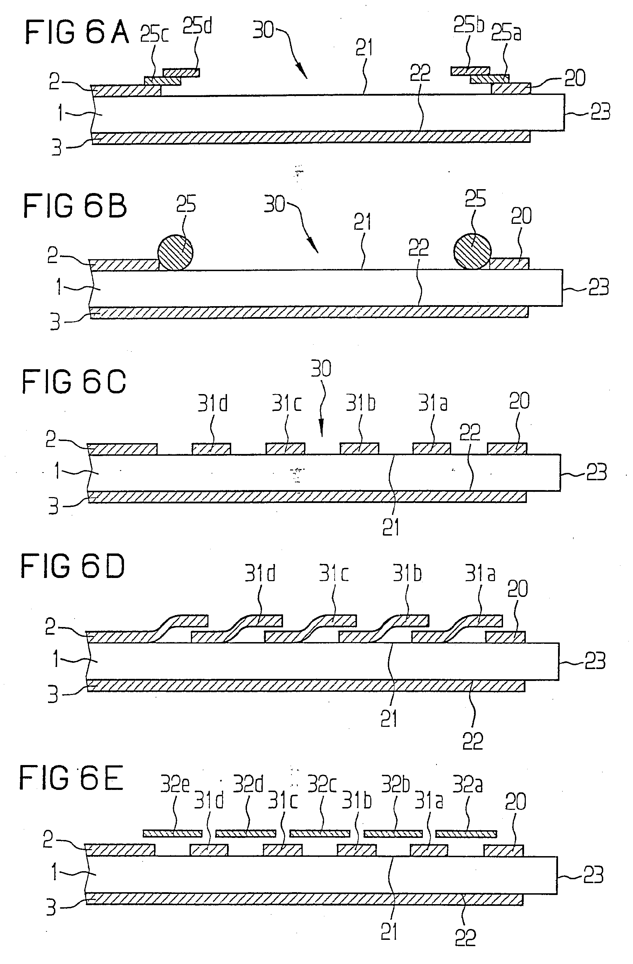

Bei dem Beispiel gemäß Figur 5 befindet sich auf der mit der oberen Metallschicht 2 versehenen ersten Hauptseite 21 der Keramikschicht 1 am Rand der oberen Metallschicht 2 ein elektrischer Leiter 8. Dieser elektrische Leiter 8 schließt an den Rand der oberen Metallschicht 2 elektrisch leitend an und weist mit zunehmendem Abstand von der oberen Metallschicht 2 einen zunehmenden Abstand von der Keramikschicht 1 auf. Er kann z. B. die in Figur 5 dargestellte nach oben gekrümmte Formgebung aufweisen. Dieser elektrische Leiter beeinflusst die Äquipotenzialflächen am Rand der oberen Metallschicht 2, da das elektrische Feld im Inneren des elektrischen Leiters verschwindet.

Die Figuren 6a bis 6e zeigen verschiedene Ausführungsbeispiele des erfindungsgemäßen Substrats im Querschnitt. In den Figuren ist jeweils die Keramikschicht 1, die untere Metallisierung 3 sowie die oberen Metallisierung 2 dargestellt. Der seitliche Rand der oberen Metallschicht 2 ist bei diesen Ausführungsbeispielen weiter von der seitlichen Begrenzung 23 der Keramikschicht 1 entfernt als der seitlich Rand der unteren Metallschicht 3. Auf der ersten Hauptseite 21 der Keramikschicht 1 ist eine Randmetallisierung 20 vorhanden, die in den vorliegenden Figuren zu der seitlichen Begrenzung 23 genauso weit entfernt ist, wie der seitliche Rand der unteren Metallschicht 3. Die untere Metallschicht 3 braucht nicht so weit bis zum Rand des Keramik-Substrates aufgebracht zu sein; ein weit außen vorhandener Rand der unteren Metallschicht hat aber fertigungstechnische Vorteile, weil insbesondere die korrekte Befestigung der unteren Metallschicht auf der Bodenplatte 5 mittels der Lötverbindung 4 so besser überprüft werden kann. Die Randmetallisierung 20 ist von dem seitlichen Rand der oberen Metallschicht 2 beabstandet, so dass dazwischen ein Feldaustrittsbereich 30 gebildet wird. Der Feldaustrittsbereich 30 definiert den Übergangsbereich des elektrischen Feldes von der Keramikschicht 1 zur (nicht gezeigten Vergußmasse) mittels der Randmetallisierung 20, die elektrisch leitend mit der unteren Metallschicht 3 bzw. der elektrisch leitfähigen Bodenplatte 5 verbunden ist. Somit ist auf einfache Weise eine Reduktion der Feldstärkespitzen an den Kanten des Feldaustrittsbereichs möglich. Zur Verringerung der Feldstärkespitzen ist eine Vielzahl von Ausgestaltungsmöglichkeiten der Randmetallisierung 20 bzw. des seitlichen Randes der oberen Metallschicht 2 denkbar. In Figur 6a sind Feldplatten 25a bis 25d stufenförmig in Richtung des Feldaustrittsbereichs 30 vorgesehen. Die Feldplatten 25a bis 25d sind dabei elektrisch leitend mit der Randmetallisierung 20 bzw. der oberen Metallschicht 2 verbunden. In Figur 6a sind die Ränder zweifach gestuft. Es wäre selbstverständlich auch denkbar, eine andere Anzahl an Stufen zu wählen.

Anstelle der mehrfach gestuften Feldplatten läßt sich auch ein Drahtring 25 mit passend gewähltem Durchmesser nach Figur 6b verwenden, der den Potenziallinien einen kleinsten Krümmungsradius aufzwingt. In der Anordnung nach Figur 6c werden im Feldaustrittsbereich 30 angeordnete flautende Festplatten benutzt, um das elektrische Feld im Feldaustrittsbereich 30 aus der Keramikschicht 1 zu vergleichmäßigen. Die Feldplatten 31a bis 31d sind gleichmäßig zueinander beabstandet zwischen der Randmetallisierung 20 und der oberen Metallschicht 2 auf der ersten Hauptseite 21 angeordnet. Die Anzahl der Feldplatten 31a bis 31d kann selbstverständlich auch von den gezeigten vier Feldplatten abweichen. Die Figuren 6d und 6e zeigen alternative Strukturen mit flautenden Feldplatten 31a bis 31d, die durch ihre Überlappungsbereiche stärker kapazitiv gekoppelt sind. Somit ist eine weitere Vergleichsmäßigung der Potenziallinien möglich. Die Feldplatten 32a bis 32e in Figur 6e können beispielsweise über eine dielektrische Schicht, welche auf die erste Hauptseite 21 aufgebracht ist, angeordnet werden.

## Patentansprüche

1. Substrat für Hochspannungsmodule mit
- einer Keramikschicht (1) mit einer ersten Hauptseite (21) und einer der ersten gegenüberliegenden zweiten Hauptseite (22),
- einer oberen Metallschicht (2) auf der ersten Hauptseite und einer unteren Metallschicht (3) auf der zweiten Hauptseite und
- einer elektrisch leitfähigen Bodenplatte (5), die über die untere Metallschicht (3) mit der Keramikplatte (1) verbunden ist
**dadurch gekennzeichnet**, daβ
auf der ersten Hauptseite (21) der Keramikschicht (1) eine zu der oberen Metallschicht (2) beabstandete Randmetallisierung (20) vorgesehen ist, die die obere Metallschicht (2) zur Bildung eines Feldaustrittsbereiches (30) rings umgibt und die niederohmig mit der unteren Metallschicht (3) verbunden ist.

2. Substrat nach Anspruch 1,
**dadurch gekennzeichnet, dass**
die dem Feldaustrittsbereich (30) zugewandten Ränder der oberen Metallschicht (2) und der Randmetallisierung (20) im Querschnitt kreisförmig oder zumindest einmal gestuft ausgebildet ist.

3. Substrat nach Anspruch 1,
**dadurch gekennzeichnet, dass**
im Feldaustrittsbereich (30) zumindest eine weitere Metallisierung (31a - 31d) zur kapazitiven Kopplung der oberen Metallschicht (2) und der Randmetallisierung (20) vorgesehen ist.

4. Substrat nach einem der Ansprüche 1 bis 3,
**dadurch gekennzeichnet, dass**
im Feldaustrittsbereich (30) auf der ersten Hauptseite (21) eine an die obere Metallschicht (2) und die Randmetallisierung (20) angrenzende hochohmige Schicht (17) aufgetragen ist.

5. Substrat nach einem der Ansprüche 1 bis 4,
**dadurch gekennzeichnet, dass**
auf der ersten Hauptseite (21) an den Rändern der oberen Metallschicht (2) elektrische Leiter (8) vorhanden sind, die so geformt sind, dass sie mit zunehmendem Abstand von der oberen Metallschicht (2) einen zunehmenden Abstand von der Keramikschicht (1) aufweisen.
